# EUROPEAN PATENT APPLICATION

(11) **EP 3 444 373 A1**
(43) Date of publication of application: **20.02.2019**
(21) Application number: 17757655.0
(22) Date of filing: 13.01.2017
(51) Int. Cl.: C23C 14/24

(54) **LINEAR EVAPORATION SOURCE, EVAPORATION SOURCE SYSTEM AND VAPOUR DEPOSITION DEVICE**

(30) Priority: 07.04.2016 CN 201620286974 U
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: ZHANG, Jinzhong, Beijing 100176 (CN)
(74) Representative: Gesthuysen Patent- und Rechtsanwälte
(86) International application number: PCT/CN2017/071044
(87) International publication number: WO 2017/173875

(57) **Abstract**

A linear evaporation source, an evaporation source system, and an evaporation device are disclosed. The linear evaporation source is applied to fabricate a light-emitting layer of an organic electroluminescence display, to improve uniformity in thickness of the light-emitting layer along a linear arrangement direction of evaporation sources. The linear evaporation source comprises a heating device for evaporating evaporation materials. A linear nozzle group is positioned on a nozzle mounting surface of the heating device, and comprises nozzles on the nozzle mounting surface along the linear arrangement direction. The heating device is equipped with a temperature compensation plate to provide a uniform heating temperature for the heating device. The evaporation source system comprises the linear evaporation sources. The linear evaporation source is applicable to the evaporation device.

## Description

### TECHNICAL FIELD

The present disclosure relates to the field of fabricating a display device, and particularly to a linear evaporation source, an evaporation source system, and an evaporation device.

### BACKGROUND

An organic electroluminescence display is a current driven type semiconductor light-emitting device based on an organic electroluminescence material. The organic electroluminescence display primarily operates as follow. A voltage is applied to a light-emitting layer through a metal electrode, so that the organic electroluminescence material in the light-emitting layer emits light for realizing images response. It has drawn attention due to advantages of low power consumption, high contrast, high color gamut, and potential for realizing flexible display.

Currently, during fabricating an organic electroluminescence display, a linear evaporation source evaporation process is generally utilized to evaporate an organic electroluminescence material onto a target substrate, so as to form the light-emitting layer of the organic electroluminescence display. But the film thickness of the resulting light-emitting layer is not uniform along a linear arrangement direction of evaporation sources, so that the resulting organic electroluminescence displays has a relatively poor display effect.

### SUMMARY

It is an object of the disclosure is to provide a linear evaporation source, an evaporation source system, and an evaporation device, so as to increase uniformity in thickness of the light-emitting layer along a linear arrangement direction of evaporation sources when the linear evaporation source evaporation process is employed to form the light-emitting layer of the organic electroluminescence display.

To realize the above object, in one aspect, the disclosure provides a linear evaporation source which comprises a heating device for evaporating evaporation materials. The linear nozzle group is positioned on a nozzle mounting surface of the heating device. The linear nozzle group comprises a plurality of nozzles which are positioned on the nozzle mounting surface along a linear arrangement direction of the evaporation sources. The heating device is equipped with a temperature compensation plate which is configured to provide a uniform heating temperature for the heating device uniform.

In an optional embodiment, the heating device comprises a heating part which is located in the temperature compensation plate. The temperature compensation plate is thin at a position corresponding to that of the heating part where the heating temperature is high, and is thick at a position corresponding to that of the heating part where the heating temperature is low.

In an optional embodiment, the temperature compensation plate has a separated structure or an integrated structure.

In an optional embodiment, the temperature compensation plate comprises a plurality of temperature compensation units. The plurality of temperature compensation units are arranged along the linear arrangement direction of the evaporation sources.

In an optional embodiment, the nozzles in the linear nozzle group have diameters which gradually increase or decrease in a direction from a center of the linear nozzle group to both sides of the linear nozzle group.

In a second aspect, the disclosure provides an evaporation source system, which comprises at least two linear evaporation sources as described above. Each of the linear evaporation sources is arranged along the linear arrangement direction of the evaporation sources.

In an optional embodiment, in each of the linear evaporation sources, two baffles are arranged on the nozzle mounting surface and configured to adjust evaporation areas of each linear evaporation source. The linear nozzle group is located between the two baffles.

In an optional embodiment, in each of the linear evaporation sources the two baffles have a height difference for adjusting the evaporation areas. The height of each baffle is a length by which the baffle extends beyond the nozzle mounting surface.

In an optional embodiment, there are two linear evaporation sources, and heights of the baffles are set in such a manner that evaporation angles of the linear evaporation sources lie in a range of 40°-55° or 70°-90°.

In a third aspect, the disclosure provides an evaporation device, which comprises the linear evaporation source as described above or the evaporation source system as described above.

As compared with the prior art, the linear evaporation source of the disclosure has the following advantageous effects.

In the linear evaporation source of the disclosure, a temperature compensation plate is arranged in the heating device and the temperature compensation plate is capable of making the heating temperature of the heating device more uniform. As a result, when heated by the heating device, the evaporation rates of the evaporation materials become more uniform. The evaporation materials are evaporated into evaporation gases, and the evaporation gases are ejected from each nozzle and evaporated onto target substrates. In this case, the thickness of the evaporation films formed by the evaporation gas becomes more uniform. Since a plurality of nozzles are positioned on the nozzle mounting surface along the linear arrangement direction of the evaporation sources, the thickness of the evaporation films formed by the evaporation gas which is ejected from each nozzle onto the target substrates is more uniform. Therefore, when using the linear evaporation sources to evaporate the evaporation materials onto the target substrates, uniformity in thickness of the made evaporation films along the linear arrangement direction of the evaporation sources is relatively good. The organic electroluminescence material is a specific evaporation material. When the evaporation material is an organic electroluminescence material, the linear evaporation sources of the disclosure can be utilized to evaporate the organic electroluminescence material. This increases uniformity in thickness along the linear arrangement direction of the evaporation sources of the light-emitting layer formed on the target substrates by the organic electroluminescence material.

### BRIEF DESCRIPTION OF THE DRAWINGS

The accompanying drawings are provided for further understanding of the disclosure and constitute a part of the disclosure. Exemplary embodiments of the disclosure and their explanations are used for explaining the disclosure rather than unduly limiting the protection scope of the disclosure. In the drawings:
Fig. 1 is a structural diagram for illustrating linear evaporation sources in an embodiment of the disclosure;
Fig. 2 is a diagram for illustrating a testing result for uniformity in film thickness of the evaporation films when the heating part in the embodiments of the disclosure is before the temperature composition and after the temperature compensation;
Fig. 3 is a diagram for illustrating a testing result for uniformity in film thickness of the evaporation films before and after the change of diameters of nozzles in the embodiment provisions of the disclosure;
Fig. 4 is a structural diagram for illustrating bicomponent linear evaporation sources in the prior art;
Fig. 5 is a structural diagram for illustrating an evaporation source system in an embodiment of the disclosure;
Fig. 6 is a diagram for illustrating a testing result for mixing uniformity of the bicomponent evaporation films in the evaporation source system in an embodiment of the disclosure, wherein evaporation angles of each linear evaporation source are 70°-90°;
Fig. 7 is a diagram for illustrating a testing result for mixing uniformity of the bicomponent evaporation films in the evaporation source system in an embodiment of the disclosure, wherein evaporation angles of each linear evaporation source are 40°-55°; and
Fig. 8 is a diagram for illustrating a testing result for mixing uniformity of the evaporation films in the evaporation source system in an embodiment of the disclosure, wherein diameters of nozzles of each linear evaporation source increase and mounting angles of nozzles decrease.

Reference numerals: 1 heating device, 10 heating part, 2 linear nozzle group, 20 nozzle, 3 temperature compensation plate, 30 temperature compensation unit, 4 bicomponent evaporation film, 41 first material layer, 42 second material layer, 100 first linear evaporation source, 101 first left-side baffle, 102 first right-side baffle, 200 second linear evaporation source, 201 second left-side baffle, 202 second right-side baffle.

### DETAILED DESCRIPTION OF EMBODIMENTS

The linear evaporation source, the evaporation source system, and the evaporation device in embodiments of the disclosure will be described in details hereinafter with reference to the drawings, to provide further explanations thereof.

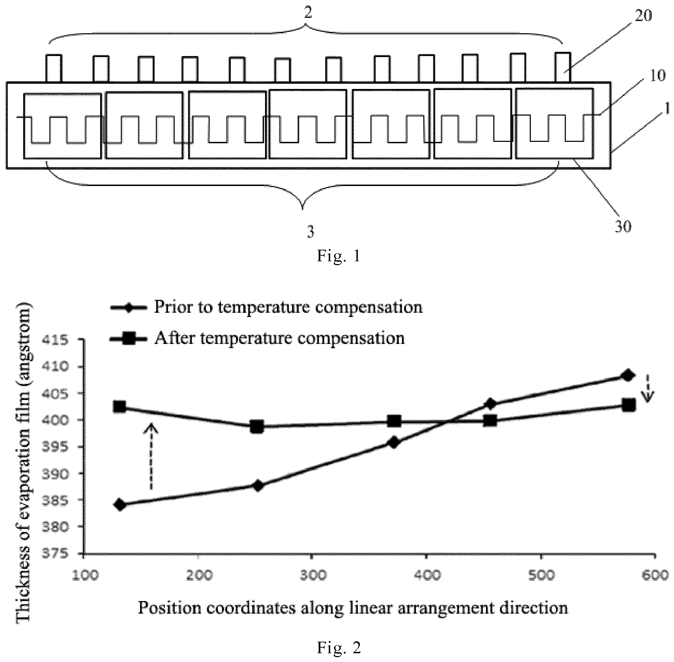

With reference to Fig. 1, linear evaporation sources in an embodiment of the disclosure comprise a heating device 1 for evaporating evaporation materials. A linear nozzle group 2 is positioned on a nozzle mounting surface of the heating device 1. The linear nozzle group 2 comprises a plurality of nozzles 20 positioned on the nozzle mounting surface along the linear arrangement direction of the evaporation sources. The heating device 1 is provided with a temperature compensation plate 3 which is capable of making the heating temperature uniform. The linear arrangement direction of the evaporation sources may also be referred to as the arrangement direction of the nozzle group 2.

In practice, the evaporation materials are loaded into the heating device, the heating device is started, and the temperature compensation plate 3 is controlled for compensating the temperature of the heating device 1. As a result, the heating temperature of the heating device 1 is uniform, so that evaporation rates of the evaporation materials become uniform. When the evaporation gases formed by evaporating the evaporation materials are ejected from each nozzle and are evaporated onto the target substrates, uniformity in thickness of the resulting evaporation films is increased.

As known from the practice of the above linear evaporation sources, since the temperature compensation plate 3 is positioned in the heating device 1 and the temperature compensation plate 3 is capable of making the heating temperature of the heating device 1 uniform. In this way, evaporation rates of the evaporation materials become uniform when the evaporation materials are heated by the heating device 1, so that the film thickness of the resulting evaporation films tend to be uniform when the evaporation gases formed by evaporation of evaporation materials are ejected from each of the nozzles 20 and evaporated onto the target substrates. Since the plurality of nozzles 20 are positioned on the nozzle mounting surface along the linear arrangement direction of the evaporation sources, the thickness of the evaporation films formed by the evaporation gases which are ejected from each nozzle onto the target substrates trends to be uniform. Therefore, when the linear evaporation sources are applied to evaporate evaporation materials onto the target substrates, uniformity in thickness of the made evaporation films along the linear arrangement direction of the evaporation sources is relatively good. The organic electroluminescence material is a specific evaporation material. When the evaporation material is an organic electroluminescence material, the linear evaporation sources of the disclosure may be utilized to evaporate the organic electroluminescence material. Accordingly, the light-emitting layer formed on the target substrates by the organic electroluminescence material has increased uniformity in thickness along the linear arrangement direction of the evaporation sources.

The heating parts 10 of the heating device 1 may have a plurality of heating positions due to many factors. The plurality of heating positions have different heating temperatures individually. Due to these heating positions, the heating part exhibits such a temperature gradient that the temperature gradually decreases. As a result, when the evaporation materials are heated by heating parts 10, the heated evaporation materials show different evaporation rates at positions corresponding to different heating positions of the heating parts 10. Accordingly, the film thickness of the evaporation films formed by evaporation materials is non-uniform. With further reference to Fig. 1, in order to avoid the occurrence of such problems, the heating parts 10 of the heating device 1 are limited within the temperature compensation 3. Besides, on basis of different heating temperatures of the plurality of heating positions, the temperature compensation plate 3 is different in thickness at portions corresponding to the heating positions. That is, the portions of the temperature compensation plate 3 corresponding to the heating positions with a higher heating temperature is thin and the portions of the temperature compensation plate 3 corresponding to the heating positions with a lower heating temperature is thick. In this way, the heating parts 10 of the heating device 1 are heat-insulated at the positions with a lower temperature by the thick portion of the temperature compensation plates 3, and this reduces the heat loss of the heating part. The temperature distribution of the heating parts 10 is more uniform and it is ensured that evaporation rates of the evaporation materials in heating device 1 are uniform.

It is noted that the heating device 1 in above embodiments may be not only common crucibles but also other equivalent devices, and that the heating parts 10 are generally heating wires, although other equivalent means is not excluded.

It is noted that when the evaporation materials are evaporated onto target substrates to form evaporation films, the temperatures of heating parts 10 generally show a gradient along the linear arrangement direction. In the prior art, this would lead to the appearance of thickness gradients of evaporation films along the linear arrangement direction. Therefore, to improve the temperature distribution of the heating part, the temperature compensation plate 3 may be arranged along the linear arrangement direction, so that the temperature distribution of the heating parts 10 is more uniform in the linear arrangement direction. With reference to Fig. 2, as proved by experiments, when the heating parts 10 show a temperature gradient in the linear arrangement direction, the film thickness of the resulting evaporation film in the linear arrangement direction after the temperature compensation achieved by the temperature compensation plate 3 is relatively more uniform.

It is noted that the temperature compensation plate 3 in above embodiments comprises several temperature compensation units 30, which are arranged in the linear arrangement direction. The temperature compensation plate 3 may have either an integrated structure or a separated structure. When the temperature compensation plate 3 has an integrated structure, the temperature compensation units 30 of the temperature compensation plate 3 have a one-piece structure. When the temperature compensation plate 3 has a separated structure, the temperature compensation units 30 are combined together and each temperature compensation unit 30 is independently capable of performing temperature compensation at different positions of the heating parts 10. In this way, temperature compensation at each position of the heating parts 10 may be precisely achieved and the temperature compensation efficiency is increased.

Moreover, as for both the temperature plate 3 of an integrated structure and the temperature plate 3 of an integrated structure, the temperature compensation plate 3 may achieve the temperature compensation to the heating parts 10 by adjusting the thickness of the temperature compensation units. The integrated temperature compensation plate 3 performs the temperature compensation to the heating parts 10 as a whole. This temperature compensation plate 3 is obtained by a molding technique. During the preparing process, the thickness of the portions of temperature compensation plate 3 corresponding to heating temperatures is formed according to the positions of the heating parts 10 with different heating temperatures. This results in a complex process for the temperature compensation plate 3. However, the separate temperature compensation plate is combined from several temperature compensation units. During fabricating, each temperature compensation unit is firstly prepared and then temperature compensation units are combined together. Each temperature compensation unit 30 may independently perform temperature compensation at different heating positions of the heating parts 10, and each heating position area is relatively small. Even if the temperature gradients appear, they fall within an acceptable range. Therefore, during fabricating a temperature compensation unit, there is no need to control the thickness of each part of the temperature compensation unit, but to adjust the whole thickness of the temperature compensation unit at position corresponding to the heating positions of different heating temperatures.

It is known from above analysis that, as compared to the integrated temperature compensation plate, the separate compensation plate not only increases the efficiency for temperature compensation of the heating parts but also decreases the fabrication complexity of each temperature compensation unit in the temperature compensation plate 3.

Moreover, when the internal pressure of the heating device 1 is not uniform, ejecting pressures of the evaporation gases from each nozzle formed by evaporation of evaporation materials are different, and this causes the film thickness distribution of the evaporation film to have a U shape. To solve this problem, diameter of each nozzle may be adjusted so that the evaporation gases have a same ejecting pressure. In other words, by adjusting diameters of nozzles 20, the internal pressure of the heating device 1 may be changed, so that the evaporation gases with a higher pressure at certain positions of the heating device 1 pass through a nozzle with a larger diameter and the pressure is decreased, and the evaporation gases with a lower pressure at certain positions of the heating device 1 pass through a nozzle with a smaller diameter and the pressure is increased.

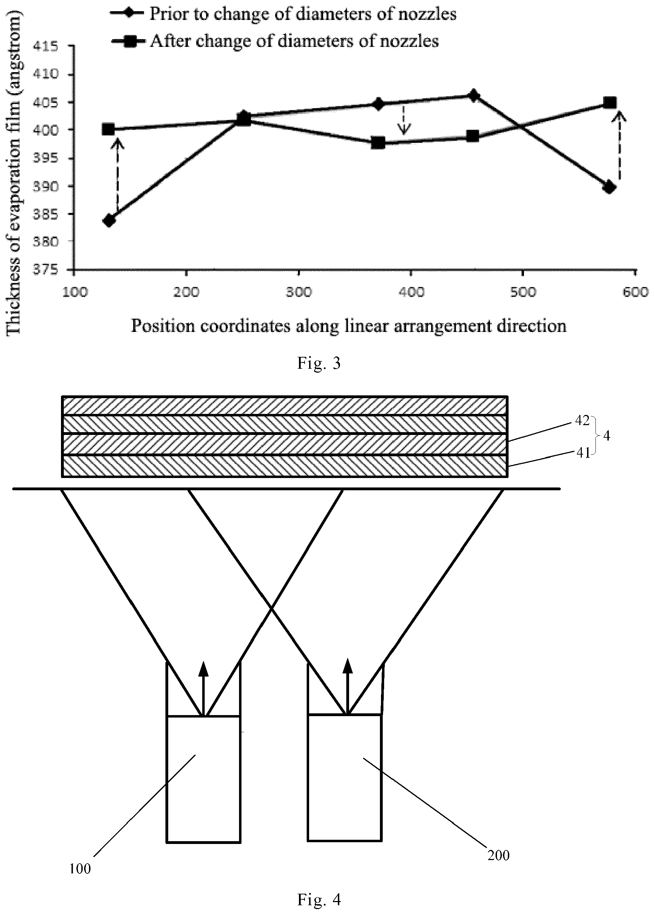

For example, it is assumed that the film thickness distribution of the evaporation film has an inverted U shape. That is, the evaporation film is relatively thick in the central portion while relatively thin at both sides along the linear arrangement direction. In an embodiment of the disclosure, the nozzles 20 in the linear nozzle group 2 have diameters which increase gradually in a direction from a center of the linear nozzle group 2 to both sides of the linear nozzle group 2. With reference to Fig. 3, as proved by experiments, a nozzle 20 with a large diameter in the linear nozzle group 2 leads to a thicker portion of the evaporation film. Thus, the linear nozzle group 2 in embodiments of the disclosure improves uniformity in thickness of the evaporation film.

On the contrary, the film thickness distribution of the evaporation film has an upward U shape. That is, the evaporation film is relatively thin in the central portion while relatively thick at both sides along the linear arrangement direction. In another embodiment of the disclosure, the nozzles 20 in the linear nozzle group 2 have diameters which decrease gradually in a direction from a center of the linear nozzle group 2 to both sides of the linear nozzle group 2, which improves uniformity in thickness of the evaporation film.

An embodiment of the disclosure further provides an evaporation source system, which comprises at least two linear evaporation sources as described above. The linear evaporation sources are arranged along the linear arrangement direction of the linear evaporation sources.

As compared with the prior art, the evaporation source system in the embodiment have the same beneficial effects as those of the linear evaporation sources, which are not repeated here for simplicity.

The evaporation source system in the embodiment comprises at least two linear evaporation sources. When a plurality of kinds of evaporation materials are contained in the evaporation film, this is achieved by adding different evaporation materials into each linear evaporation source and evaporating these evaporation materials onto a same target substrate. Since different evaporation materials are loaded to each linear evaporation source, the evaporation angle of each linear evaporation source must be considered. Otherwise, the resulting evaporation film is prone to layering, which leads to poor mixing uniformity of the evaporation film.

For example, Fig. 4 discloses an evaporation source system, comprising a first linear evaporation source 100 and a second linear evaporation source 200. Due to evaporation angles of the first and second linear evaporation source 100, 200, an evaporation film 4 consisting of two materials, which is also referred to as a bicomponent evaporation film, is formed on the target substrate by directly using the first and second linear evaporation source 100, 200 to evaporate individual evaporation materials. The evaporation film 4 is subject to layering to form a bicomponent evaporation film, in which a first material layer 41 and a second material layer 42 appear alternately. This leads to poor mixing uniformity of the evaporation film 4.

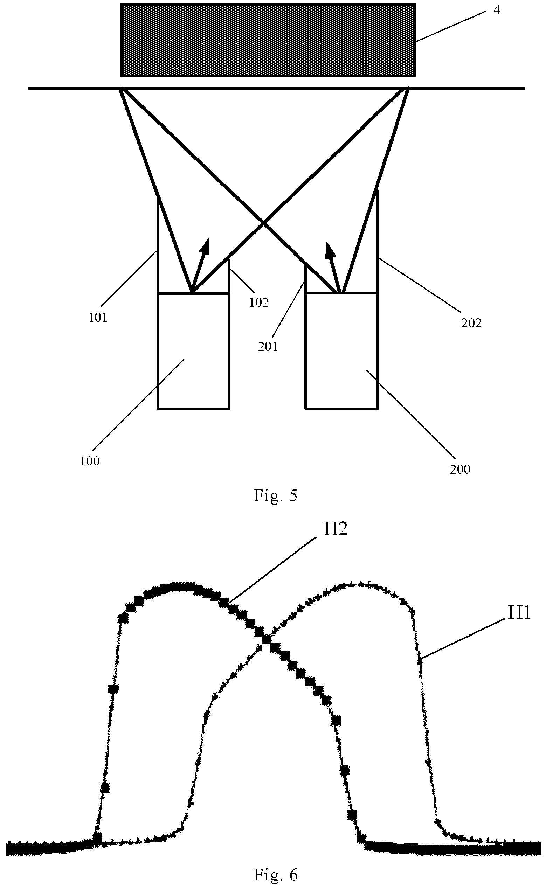

To overcome the above problems, with reference to Fig. 5, evaporation areas of linear evaporation sources as described above overlap. Therefore, even if each linear evaporation source comprises a different evaporation material, the evaporation materials of linear evaporation sources have coincident distribution areas on the target substrate. In this way, when evaporation materials are evaporated by different linear evaporation sources, each evaporation material may be mixed fully in a same area. In case these evaporation materials are different kinds of organic electroluminescence materials, it is guaranteed that organic electroluminescence materials in a light-emitting layer may be mixed uniformly during forming the light-emitting layer.

With reference to Fig. 5, particularly, two baffles which can adjust evaporation areas of linear evaporation sources are arranged on the nozzle mounting surface. The linear nozzle group is located between these two baffles. The baffles adjust the height difference between the evaporation areas and thus adjust evaporation areas of the linear evaporation sources. The height of the baffles may be defined as the length that the baffles extend beyond the nozzle mounting surface. By adjusting the height differences of two baffles, the corresponding evaporation angles of the linear evaporation sources are adjusted. This makes the evaporation angles of the linear evaporation sources enough to cover the target substrate, namely, the evaporation area. Therefore, by adjusting the height differences of two baffles of two linear evaporation sources, evaporation angles of evaporation sources can be adjusted so that evaporation angles of linear evaporation sources cover the same evaporation area. When the target substrate is located in this area, it is guaranteed that the evaporation gases evaporated from linear evaporation sources are mixed fully on the target substrate and that uniformly mixed evaporation films are formed. The evaporation angles of linear evaporation sources may be selected according to the actual situation, as long as the evaporation areas of linear sources overlap with each other. Moreover, in an example, the angle between the baffle and the nozzle mounting surface is 90°.

It is noted that the linear evaporation sources operate in a same manner as the one described above, regardless of the number of the linear evaporation sources in the evaporation source system. With reference to Fig. 5, a particular evaporation source system will be described hereinafter.

As shown in Fig. 5, the evaporation source system comprises a first linear evaporation source 100 and a second linear evaporation source 200.

A first left-side baffle 101 and a first right-side baffle 102 are positioned on a linear evaporation surface of the first linear evaporation source 100. The first left-side baffle 101 is higher than the first right-side baffle 102.

A second left-side baffle 201 and a second right-side baffle 202 are positioned on a linear evaporation surface of the second linear evaporation source 200. The second right-side baffle 202 is higher than the second left-side baffle 201.

In practice, a first evaporation material is loaded into the first linear evaporation source, and a second evaporation material is loaded into the second linear evaporation source.

The height difference between the first left-side baffle 101 and the first right-side baffle 102 of the first linear evaporation source 100 is adjusted so that the evaporation area of the first linear evaporation source 100 covers the target substrate. The height difference between the second right-side baffle 202 and the second left-side baffle 201 of the second linear evaporation source 200 is adjusted so that the evaporation area of the second linear evaporation source 200 covers the target substrate.

When both the evaporation area of the first linear evaporation source 100 and the evaporation area of the second linear evaporation source 200 cover the target substrate, the first evaporation material is evaporated by the first linear evaporation source 100 and the second evaporation material is evaporated by the second linear evaporation source 200. As a result, the first evaporation material and the second evaporation material are mixed on the target substrate to form a bicomponent evaporation film 4.

With reference to Fig. 6, the evaporation angles of both the first linear evaporation source 100 and the second linear evaporation source 200 are 70°-90°. In this case, the evaporation area of the first linear evaporation source 100 (represented as HI) does not overlap with the evaporation area of the second linear evaporation source 200 (represented as H2) in a satisfactory manner. The mixing uniformity of the resulting bicomponent evaporation film is poor, and may even be 0.

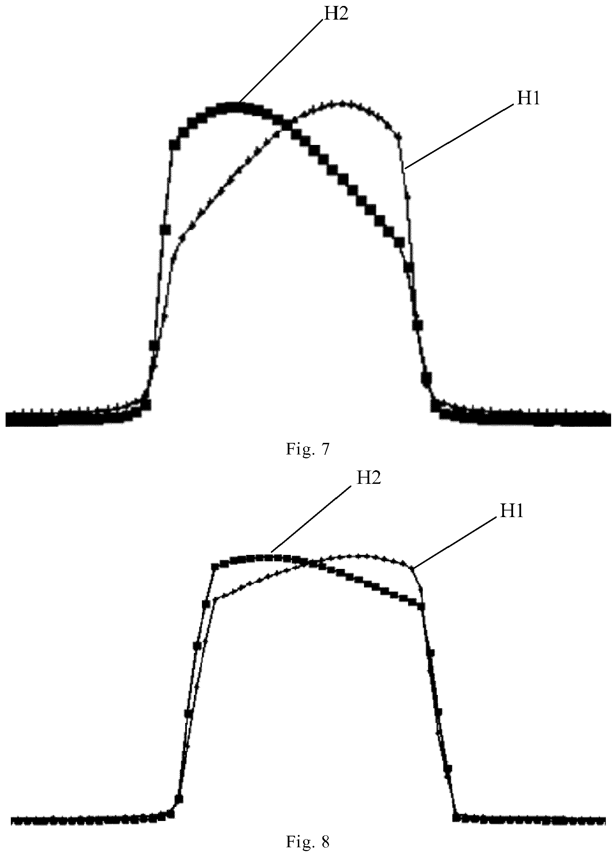

With reference to Fig. 7, the evaporation angles of both the first linear evaporation source 100 and the second linear evaporation source 200 are 40°-55°. In this case, the mixing uniformity of the bicomponent evaporation film 4 is improved, and the mixing uniformity of the resulting bicomponent evaporation film is about 70%.

In above embodiments the evaporation angle of the first linear evaporation source 100 may be adjusted by utilizing the height difference between the first left-side baffle 101 and the first right-side baffle 102 and the evaporation angle of the second linear evaporation source 200 may be adjusted by utilizing the height difference between the second right-side baffle 102 and the first left-side baffle 101. However, the mixing uniformity of the bicomponent evaporation film 4 still cannot reach 100%. This is because evaporation materials are ejected from nozzles at different rates in various directions and the nozzles have a function of guiding the gas flows. Therefore, the evaporation rate Vc along the axial direction of the nozzle has the largest value and the evaporation rate Vs at both sides of the nozzles gradually decreases. In this way, when evaporation materials are evaporated onto the target substrate in various directions, the amount of evaporated materials gradually decreases from the axial direction as a center to both sides. Therefore, the mixing uniformity of the bicomponent evaporation film 4 can be improved by reducing a mounting angle of each nozzle between each axis of the nozzle and its corresponding linear mounting surface and increasing the diameter of each nozzle. With reference to Fig. 8, it is proved by the experiment that the mixing uniformity of the bicomponent evaporation film 4 is increased to 85% or more.

In the above embodiments, the nozzle mounting angle of the first linear evaporation source 100 may match the nozzle mounting angle of the second linear evaporation source 200, so that the first linear evaporation source 100 and the second linear evaporation source 200 may mutually compensate the thickness differences of the individually evaporated films.

An embodiment of the disclosure further provides an evaporation device, which comprises the linear evaporation source as described above or the evaporation source system as described above.

As compared to the prior art, the evaporation device in the embodiment has same beneficial effects as the linear evaporation source as described above or the evaporation source system as described above, which are not repeated herein for simplicity.

In description of the above embodiments, particular features, structures, materials, or characteristics can be combined appropriately in any one or more embodiments or examples.

What have been described above are only particular implementations of the disclosure, while the protection scope of the disclosure is not limited to this. Any variation or alternation which can be easily thought by any skilled person in the art falls within the scope of the disclosure. Therefore, the protection scope of the disclosure is defined by the appended claims.

## Claims

1. A linear evaporation source, comprising a heating device for evaporating evaporation materials,
wherein a linear nozzle group is positioned on a nozzle mounting surface of the heating device;
wherein the linear nozzle group comprises a plurality of nozzles which are positioned on the nozzle mounting surface along a linear arrangement direction of the evaporation source; and
wherein the heating device is equipped with a temperature compensation plate which is configured to provide a uniform heating temperature for the heating device.

2. The linear evaporation source of claim 1, wherein the heating device comprises a heating part which is located in the temperature compensation plate; and
wherein the temperature compensation plate is thin at a position corresponding to that of the heating part where the heating temperature is high, and is thick at a position corresponding to that of the heating part where the heating temperature is low.

3. The linear evaporation source of claim 1 or 2, wherein the temperature compensation plate has a separated structure or an integrated structure.

4. The linear evaporation source of claim 3, wherein the temperature compensation plate comprises a plurality of temperature compensation units which are arranged along the linear arrangement direction.

5. The linear evaporation source of claim 1 or 2, wherein the nozzles in the linear nozzle group have diameters which gradually increase or decrease in a direction from a center of the linear nozzle group to both sides of the linear nozzle group.

6. An evaporation source system, comprising at least two linear evaporation sources of any of claims 1 to 5, wherein each of the linear evaporation sources is arranged along the linear arrangement direction.

7. The evaporation source system of claim 6, wherein in each of the linear evaporation sources, two baffles are arranged on the nozzle mounting surface and are configured to adjust evaporation areas of each linear evaporation source; and
wherein the linear nozzle group is located between the two baffles.

8. The evaporation source system of claim 7, wherein in each of the linear evaporation sources, the two baffles have a height difference for adjusting the evaporation areas; and
wherein a height of each baffle is a length by which the baffle extends beyond the nozzle mounting surface.

9. The evaporation source system of claim 8, wherein the baffle close to the perimeter of the evaporation source system is higher than the baffle close to a center of the evaporation source system.

10. The evaporation source system of claim 7 or 8, wherein there are two linear evaporation sources, and
wherein heights of the baffles are set in such a manner that evaporation angles of the linear evaporation sources lie in a range of 40°-55°.

11. An evaporation device, comprising the linear evaporation source of any of claims 1-5 or the evaporation source system of any of claims 6-10.
